# EUROPÄISCHE PATENTANMELDUNG

(11) **EP 0 792 946 A1**
(43) Veröffentlichungstag der Anmeldung: **03.09.1997**
(21) Anmeldenummer: 97100169.8
(22) Anmeldetag: 08.01.1997
(51) Int. Cl.: C23C 14/26

(54) **Verdampferschiffchen zur Beschichtung von Substraten**

(30) Priorität: 28.02.1996 DE 19607400
(71) Anmelder: Balzers und Leybold Deutschland Holding AG, 63450 Hanau (DE)
(72) Erfinder: Achtner, Wolfgang, 63477 Maintal (DE); Klemm, Günter, 63667 Nidda (DE)

(57) **Zusammenfassung**

Bei einem Verdampferschiffchen für eine Vorrichtung zur Beschichtung von Substraten in einer Vakuumbeschichtungskammer, bestehend aus einem flachen, langgestreckten trogförmigen Teil (8), aus einem elektrisch leitenden Werkstoff, das durch direkten Stromdurchgang beheizbar ist, wozu an den beiden einander diametral gegenüberliegende Enden des trogförmigen Teils (8) jeweils etwa rechteckige, sich lotrecht erstreckende Kontaktflächen (9,10) vorgesehen sind, die die einander parallelen Einspannstellen für die Halterung des trogförmigen Teils (8) und den Stromdurchgang bilden, sind auf dem trogförmigen Teil (8) eine oder mehrere hintereinander liegend angeordnete Partien (11, 11'...) zur Aufnahme des zu verdampfenden Gutes vorgesehen, wobei der trogförmige Teil (8) vor und hinter jeder Partie (11, 11'...) mit Durchbrüchen (7, 12, 12'...) oder Bohrungen versehen ist.

## Beschreibung

Die Erfindung betrifft ein Verdampferschiffchen für eine Vorrichtung zur Beschichtung von Substraten in einer Vakuumbeschichtungskammer, bestehend aus einem flachen, trogförmigen Teil aus einem elektrisch leitenden Werkstoff, das durch direkten Stromdurchgang beheizbar ist.

Es sind stromdurchflossene trogförmige Verdampferschiffchen mit rechtekkigen Grundrißflächen - insbesondere für Reihenverdampfer - bekannt, die an ihren beiden lotrechten Schmal- bzw. Stirnseiten mit Einspannflächen versehen sind, mit denen sie sich an den Schiffchenhalterungen abstützen.

Bei einer älteren Vorrichtung zur laufenden Beschichtung von bandförmigen Substraten (P 40 27 034) in einer Vakuumbeschichtungskammer mit einer Vielzahl von eine Verdampferbank bildenden, parallel zueinander und längs zur Bandlaufrichtung, in etwa gleichen Abständen zueinander angeordneten Verdampferschiffchen etwa gleicher Größe und Konfiguration, wobei die Verdampferschiffchen sämtlich aus einer elektrisch leitenden Keramik gebildet und durch direkten Stromdurchgang beheizbar sind und die eine Vorrichtung für die kontinuierliche Zuführung von zu verdampfendem Draht zu den Verdampferschiffchen aufweist, sind die einzelnen Verdampferschiffchen jeweils zueinander versetzt angeordnet, wobei alle Verdampferschiffchen gemeinsam eine schmale Beschichtungszone überdecken, die sich quer zur Bandlaufrichtung erstreckt.

Durch die versetzte Anordnung soll die Aufgabe gelöst werden, die gegenseitige Wechselwirkung der Einzelquellen zu verkleinern und dadurch die Schichtgleichmäßigkeit zu verbessern. Die einzelnen Verdampferschiffchen selbst weisen einen rechteckigen Querschnitt auf, wobei die Vertiefungen zur Aufnahme des Schmelzgutes sämtlich eine rechteckige Grundrißfläche haben.

Bei einer anderen bekannten Vorrichtung zur laufenden Bedampfung endloser Gebilde (DE 970 246) mit mehreren direkt beheizten, in einer Reihe hintereinanderliegenden Verdampfern hat man bereits versucht, einen Nachteil des konventionellen Verdampfertyps mit rechteckiger Grundfläche für die Vertiefung zu beseitigen, der sich daraus ergibt, daß das verdampfende Gut als ausgezeichneter Leiter für den elektrischen Strom den Verdampfer zum Teil kurzschließt, so daß nur die zwischen den einzelnen Vertiefungen vorhandenen Teile des Verdampfers als Wärmegenerator dienen, so daß eine ungleichmäßige Beschichtung erfolgt. Gemäß dieser vorveröffentlichten Druckschrift soll dieser Nachteil dadurch beseitigt werden, daß der Verdampfer zwischen den einzelnen Vertiefungen eine Schwächung des Verdampferquerschnitts aufweist, so daß der elektrische Widerstand des Verdampfers etwa konstant und unabhängig von der Füllmenge des Verdampfungsgutes in den Kammern ist.

In einer älteren Patentanmeldung (P 40 16 225.7) ist ein Reihenverdampfer für Vakuumbedampfungsanlagen, insbesondere für Bandbedampfungsanlagen, beschrieben, bestehend aus mehreren, einzeln in der Leistung steuerbaren, durch Stromdurchgang beheizten, an stützenförmig ausgebildeten elektrischen Zuleitungen anliegenden Verdampfern, wobei die stützenförmigen Zuleitungen von einem sich über die gesamte Länge des Reihenverdampfers erstreckenden, elektrisch leitfähigen Tragkörper gehalten sind und die Zuleitungen der einen Polarität elektrisch leitend mit dem Tragkörper verbunden sind, während die Zuleitungen der anderen Polarität isoliert durch den Tragkörper hindurchgeführt und mit isoliert angeordneten Leitungsdrähten verbunden sind, wobei sich die Verdampfer über vorzugsweise als Zylinderabschnitte ausgeformte Lagerelemente an den oberen Enden oder Nasen der Zuleitungen abstützen, wozu die Lagerelemente aus einem stromleitenden Werkstoff, beispielsweise einer Keramik, gebildet sind

Dieser ältere Reihenverdampfer löst das Problem der paarweisen Einspannung der Verdampfer zwischen den elektrischen Zuleitungen bzw. des guten elektrischen Kontakts während des Verdampfungsprozesses. Aber auch bei dieser paarweisen Anordnung von Verdampfern ist das Problem einer optimal gleichmäßigen Beschichtung noch nicht vollständig gelöst.

Schließlich ist ein Verdampferschiffchen bekannt (DE 41 39 792 A1) für eine Vorrichtung zur Beschichtung von Substraten in einer Vakuumbeschichtungskammer, bestehend aus einem flachen, trogförmigen teil aus einem elektrisch leitenden Werkstoff, wobei das Schiffchen durch direkten Stromdurchgang beheizbar ist und eine im wesentlichen rhombus- oder rhomboidförmige Grundrißfläche aufweist, wobei die Konfiguration der Vertiefung in etwa derjenigen des Schiffchens entspricht und wobei zwei einander diametral gegenüberliegenden Ecken des Verdampferschiffchens jeweils mit einer etwa rechteckigen, lotrechten Abplattung versehen sind, die zusammen die einander parallelen Einspannflächen des Verdampferschiffchens bilden.

Der vorliegenden Erfindung liegt nun die Aufgabe zugrunde, die Nachteile der bekannten Verdampfer bzw. Verdampferanordnungen zu vermeiden und den Verdampfer so auszubilden, daß eine optimale Beschichtung möglich ist.

Erfindungsgemäß wird dies dadurch erreicht, daß der trogförmige Teil in Längsrichtung vor und/oder hinter der jeweils vom aufgeschmolzenen Material benetzten Partie mit Durchbrüchen, beispielsweise sich lotrecht erstreckenden Bohrungen versehen ist.

Zweckmäßigerweise ist bei einem Schiffchen mit einer Vielzahl von in einer Reihe hinteneinanderliegend angeordneten Zonen zum Aufschmelzen des zu verdampfenden Gutes zwischen den einzelnen Partien und auch vor und hinter der jeweils letzten Partie das trogförmige Teil mit Durchbrüchen versehen.

Die Erfindung läßt die verschiedensten Ausführungsmöglichkeiten zu; zwei davon sind in der Zeichnung näher dargestellt, und zwar zeigen:
- Fig. 1,2: ein Schiffchen mit einer einzigen Verdampfungszone in der Draufsicht und im Querschnitt, wobei jeweils im Bereich der diametral einander gegenüberliegenden Einspannflächen Gruppen von Bohrungen vorgesehen sind und
- Fig. 3: ein Schiffchen nach der vorliegenden Erfindung in der Draufsicht ausgestattet mit mehreren in einer Reihe hinteneinander liegenden Zonen zum Aufschmelzen und Verdampfen des Gutes.

Bei der Kühlung der Einspannbacken der Schiffchenhalterung entsteht bei herkömmlichen Schiffchen ein Temperaturgefälle mit der heißesten Zone in der Mitte des Schiffchens. Über diese Zone von ca. 2 - 3 cm Länge (bei einer Gesamtlänge von 9 cm der Kavität) wird erfahrungsgemäß doppelt soviel Aluminium pro Flächeneinheit verdampft wie über dem Rest der Kavitätsfläche (Fläche der Senke).

Um nun eine von Spritzern freie Verdampfung und damit "pinhole"-freie Beschichtung zu erhalten, darf eine vorbestimmte (maximale) Temperatur nicht überschritten werden. Diese wird durch die Temperatur der heißen Zone definiert. Man erhält damit eine über die gesamte Kavitätsfläche gemittelte Abdampfrate. Gemäß der Erfindung soll der Temperaturgradient verringert werden, so daß eine größere Zone auf diese (maximale) Temperatur erhöht werden kann, woraus sich eine größere mittlere und von Spritzern freie Abdampfrate ergibt.

Bei der vorgesehenen stirnseitigen Einspannung des Schiffchens mit Hilfe der Backen 15, 16 ist es nun möglich, dieses Ziel ohne großen Aufwand durch die Anordnung von Durchbrechungen oder Gruppen von Bohrungen 7,7'... bzw. 12,12'... im trogförmigen Teil 3,8 zu erreichen.

Zweckmäßigerweise ist das Verdampferschiffchen bzw. dessen trogförmiger Teil 3 bzw. 8 nur etwa an 2/3 der Stirnfläche 4,5 bzw. 9,10 eingespannt, um die Kühlung der Enden zu verringern. Durch Querschnittsverringerung werden die Schiffchen in einem Bereich naher der Einspannstelle höher aufgeheizt. Im Mittelteil des Schiffchens wird das zu verdampfende Material ohne zu tropfen eingeschmolzen und verdampft.

Bei langen Schiffchen wird jede Drahtzufuhr von der benachbarten durch eine heiße Zone getrennt. Auf diese Weise kann eine wesentlich höhere Aufdampfrate ohne Spritzer als bisher erreicht werden. Bei langen Schiffchen wird der bisher bekannte Nachteil der Ungleichmäßigkeit der Abdampfrate infolge von unterschiedlicher Temperatur und Benetzung über die Schiffchenlänge beseitigt.
Das Verhältnis von heißen zu kälteren Zonen am Schiffchen kann durch die Querschnittsverringerung so eingestellt werden, daß für jede gewünschte Rate ein gleichmäßiges Abschmelzen des Drahtes ohne Tropfen gewährleistet ist.

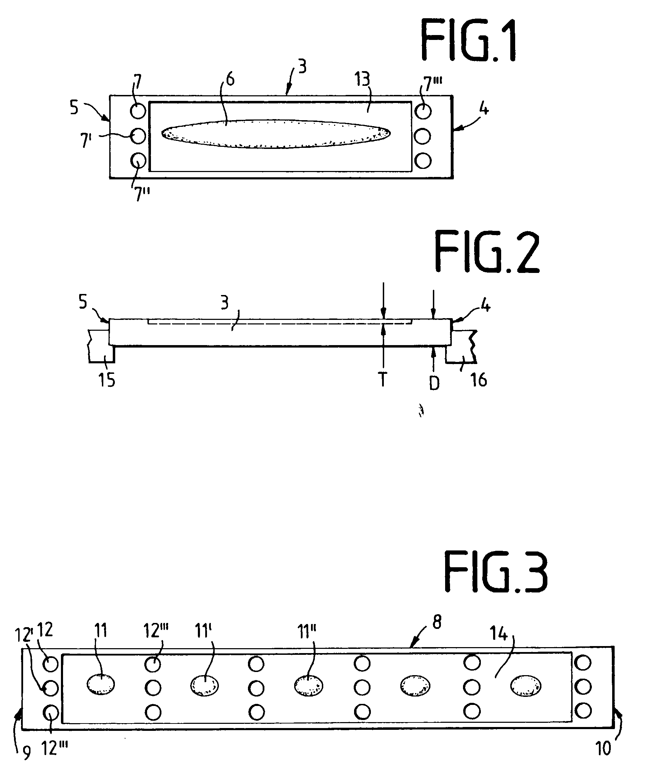

Das in Fig. 3 dargestellte lange Schiffchen weist ein besonders langes trogförmiges Teil 8 auf und ist für insgesamt fünf Schmelzzonen 11, 11'... vorgesehen; d.h., daß der aufzuschmelzende bzw. zu verdampfende Werkstoff in Form von fünf Drahtzuschnitten diesen fünf Zonen 11, 11'... zugeführt wird, wo er jeweils kleine "Schmelzseen" bildet, aus denen heraus das Material verdampft.
Die einzelnen "Schmelzseen" oder Zonen sind in der Zeichnung in Form von Ellipsen angedeutet.
Zwischen den einzelnen Zonen 11, 11'... ist jeweils eine Gruppen von drei Bohrungen 12, 12', 12''... angeordnet, die den Querschnitt des trogförmigen Teils 8 entsprechend ihren Durchmesser verringern.
Die Bohrungen 12, 12', 12'' verlaufen dabei zweckmäßigerweise lotrecht zur Trogfläche; es ist jedoch auch ohne weiteres möglich, diese quer und parallel zur Trogebene vorzusehen.

### Auflistung der Einzelteile

- 3: Trogförmiger Teil
- 4: Stirnfläche, Kontaktfläche
- 5: Stirnfläche, Kontaktfläche
- 6: Schmelzsee, Zone
- 7,7'...: Durchbruch, Bohrung
- 8: Trogförmiger Teil
- 9: Stirnfläche, Kontaktfläche
- 10: Stirnfläche, Kontaktfläche
- 11, 11'...: Schmelzsee, Zone
- 12, 12'...: Durchbruch, Bohrung
- 13: Kavität, Senke
- 14: Kavität, Senke
- 15: Einspannbacke
- 16: Einspannbacke

## Patentansprüche

1. Verdampferschiffchen für eine Vorrichtung zur Beschichtung von Substraten in einer Vakuumbeschichtungskammer, bestehend aus einem flachen, langgestreckten trogförmigen Teil (3,8), aus einem elektrisch leitenden Werkstoff, das durch direkten Stromdurchgang beheizbar ist, wozu an den beiden einander diametral gegenüberliegende Enden des trogförmigen Teils (3,8) jeweils etwa rechteckige, sich lotrecht erstreckende Kontaktflächen (4,5,9,10) vorgesehen sind, die die einander parallelen Einspannstellen für die Halterung des trogförmigen Teils (3, 8) und den Stromdurchgang bilden, **dadurch gekennzeichnet**,
daß auf dem trogförmigen Teil (3,8) eine oder mehrere hintereinander liegend angeordnete Partien (6, 11, 11'...) zur Aufnahme des zu verdampfenden Gutes vorgesehen sind, wobei der trogförmige Teil (3, 8) vor und hinter jeder Partie (6, 11, 11'...) mit Durchbrüchen (7, 7'... 12, 12'...) oder Bohrungen versehen ist.

2. Verdampferschiffchen nach Anspruch 1,
**dadurch gekennzeichnet**,
daß eine oder mehrere Verdampferzonen oder Partien (6, 11, 11'...) in einer flachen, sich auf der Oberseite des trogförmigen Teils (3, 8) in dessen Längsrichtung erstreckenden Senke oder Vertiefung (13, 14) vorgesehen sind.

3. Verdampferschiffchen nach den Ansprüchen 1 und 2,
**dadurch gekennzeichnet**,
daß die Durchbrüche jeweils aus einer Gruppe von nebeneinander und parallel zueinander angeordneten lotrechten Bohrungen (7, 7'..., 12, 12'...) gebildet sind.

4. Verdampferschiffchen nach den vorhergehenden Ansprüchen,
**dadurch gekennzeichnet**,
daß der trogförmige Teil (3, 8) eine etwa parallelepipede Konfiguration aufweist und das Verhältnis der Dicke (D) des Teils (3, 8) zur Tiefe (T) der auf seiner Oberseite befindlichen Senke (13, 14) etwa 5 beträgt.
